# EUROPÄISCHE PATENTANMELDUNG

(11) **EP 2 482 434 A2**
(43) Veröffentlichungstag der Anmeldung: **01.08.2012**
(21) Anmeldenummer: 12000586.3
(22) Anmeldetag: 30.01.2012
(51) Int. Cl.: H02M 1/08

(54) **Treiberschaltung für einen stromgesteuerten Halbleiterschalter**

(30) Priorität: 28.01.2011 DE 102011009674
(71) Anmelder: Diehl AKO Stiftung & Co. KG, 88239 Wangen (DE)
(72) Erfinder: Bertelsmann, Götz-Martin, 88239 Wangen (DE)
(74) Vertreter: Diehl Patentabteilung

(57) **Zusammenfassung**

Eine Treiberschaltung für einen stromgesteuerten Halbleiterschalter weist einen Gleichspannungswandler (DC-DC) mit einem Ausgangsanschluss (V+) zum Bereitstellen eines Ansteuerstroms für einen Halbleiterschalter (T); ein erstes Schaltelement (M1), das zwischen den Ausgangsanschluss (V+) des Gleichspannungswandlers (DC-DC) und einen Steueranschluss (G) des Halbleiterschalters (T) geschaltet ist; und ein zweites Schaltelement (M2), das zwischen den Steueranschluss (G) des Halbleiterschalters (T) und einen Stromanschluss (S) des Halbleiterschalters (T) geschaltet ist, auf. Der eine Gleichspannungswandler (DC-DC) ist dabei in zwei Betriebsmodi mit unterschiedlichen Ausgangsströmen und/oder -spannungen betreibbar.

## Beschreibung

Die vorliegende Erfindung betrifft eine Treiberschaltung für einen stromgesteuerten Halbleiterschalter und ein Verfahren zum Ansteuern eines stromgesteuerten Halbleiterschalters.

Neue Halbleiterschalter, insbesondere solche aus neuen Materialien wie beispielsweise Siliziumcarbid (SiC) oder Galliumnitrid (GaN) haben andere Anforderungen an die Ansteuerung des Steueranschlusses (Gate) als gewöhnliche Halbleiterschalter aus beispielsweise Silizium (Si). Üblicherweise benötigen sie einen Stromimpuls zum Einschalten, um die Millerkapazität (interne Streukapazität) aufzuladen, und anschließend einen niedrigeren konstanten Strom, um den Halbleiterschalter im eingeschalteten Zustand zu halten. Ihr Ausschalten erfordert ein schnelles Entladen der Millerkapazität. Derartige Halbleiterschalter werden als stromgesteuerte Halbleiterschalter bezeichnet; zu ihnen zählen beispielsweise Bipolartransistoren, JFETs, HEMTs und dergleichen.

Zum Ansteuern von stromgesteuerten Halbleiterschaltern ist es grundsätzlich möglich, zwei Spannungsquellen mit zwei zugehörigen Treiberschaltungen einzusetzen, um die zum Einschalten und zum Halten im eingeschalteten Zustand benötigten, unterschiedlichen Ansteuerströme bereitzustellen. Für das Ansteuern von spannungsgesteuerten Halbleiterschaltern wie MOSFETs ist es ferner zum Beispiel aus der US 2009/0014669 A1 bekannt, eine Treiberschaltung mit einem Gleichspannungswandler und mit zwei zur Verfügung stehenden Spannungsniveaus zu verwenden.

Es besteht deshalb Bedarf an einer Treiberschaltung für einen solchen Halbleiterschalter, welche den oben beschriebenen Anforderungen zur Ansteuerung des Steueranschlusses des Halbleiterschalters genügt und gleichzeitig möglichst einfach und zuverlässig aufgebaut ist.

Es ist die Aufgabe der vorliegenden Erfindung, eine verbesserte Treiberschaltung für einen stromgesteuerten Halbleiterschalter vorzusehen, welche die Mlllerkapazltät des Halbleiterschalters bei seinem Einschalten und Ausschalten berücksichtigt.

Diese Aufgabe wird gelöst durch eine Treiberschaltung für einen stromgesteuerten Halbleiterschalter mit den Merkmalen des Anspruches 1 bzw. ein Verfahren zum Ansteuern eines stromgesteuerten Halbleiterschalters mit den Merkmalen des Anspruches 5. Vorteilhafte Ausgestaltungen und Weiterbildungen der Erfindung sind in den abhängigen Ansprüchen angegeben.

Die erfindungsgemäße Treiberschaltung für einen stromgesteuerten Halbleiterschalter weist einen Gleichspannungswandler mit einem Ausgangsanschluss zum Bereitstellen eines Ansteuerstroms für einen Halbleiterschalter, ein erstes Schaltelement, das zwischen den Ausgangsanschluss des Gleichspannungswandlers und einen Steueranschluss des Halbleiterschalters geschaltet ist, und ein zweites Schaltelement, das zwischen den Steueranschluss des Halbleiterschalters und einen Stromanschluss des Halbleiterschalters geschaltet ist, auf. Der eine Gleichspannungswandler ist dabei in zwei Betriebsmodi mit unterschiedlichen Ausgangsströmen und/oder Ausgangsspannungen betreibbar.

Eine wesentliche Komponente der erfindungsgemäßen Treiberschaltung ist der Gleichspannungswandler, der in zwei Betriebsmodi betrieben werden kann. Durch die zwei Betriebsmodi mit unterschiedlichen Ausgangsströmen und/oder -spannungen des Gleichspannungswandlers kann dieser zwei unterschiedliche Ansteuerströme (insbesondere mit zwei unterschiedlichen Stromniveaus bzw. Amplituden) für den stromgesteuerten Halbleiterschalter bereitstellen. Ein solcher Gleichspannungswandler besitzt daher grundsätzlich die gewünschten Funktionen zum Ansteuern eines stromgesteuerten Halbleiterschalters, insbesondere auch eines Halbleiterschalters aus neuen Materialien wie SiC oder GaN. Üblicherweise wird in einem Gleichspannungswandler eine Ausgangskapazität über eine Induktivität mit programmierten Werten für die Ausgangsspannung und den Ladestrom aufgeladen. So besteht die Möglichkeit, den Halbleiterschalter mit einem sehr großen Stromimpuls aus der maximal aufgeladenen Ausgangskapazität des Gleichspannungswandlers einzuschalten und anschließend mit Hilfe des programmierten Ladestroms des Gleichspannungswandlers im eingeschalteten Zustand zu halten.

Da die Treiberschaltung mit dem Gleichspannungswandler in der Lage ist, die internen Streukapazitäten (Millerkapazität, etc.) des Halbleiterschalters schnell aufzuladen und zu entladen, kann eine hohe Schaltfrequenz des Halbleiterschalters erzielt werden.

Der Gleichspannungswandler stellt eine relativ einfache, zuverlässige und in großen Stückzahlen verfügbare Komponente dar, sodass eine zuverlässige und kostengünstige Treiberschaltung für einen stromgesteuerten Halbleiterschalter bereitgestellt werden kann. Außerdem genügen zum Ansteuern des stromgesteuerten Halleiterschalters (genau) ein Gleichspannungswandler, (genau) eine Treiberhalbbrücke (gebildet aus dem ersten und dem zweiten Schaltelement) und (genau) eine Spannungsquelle zum Speisen dieses Gleichspannungswandlers.

Der Begriff "stromgesteuerter Halbleiterschalter" umfasst in diesem Zusammenhang grundsätzlich alle Arten von stromgesteuerten Halbleiterschaltelementen. Hierzu zählen insbesondere Bipolartransistoren, JFETs (Sperrschicht-Feldeffekttransistoren) HEMTs (High-Electron-Mobility Transistoren) und dergleichen,.

Der Begriff "Schaltelement" umfasst in diesem Zusammenhang grundsätzlich alle Arten von Schaltelementen, insbesondere Halbleiterschaltelementen. Vorzugsweise sind das erste Schaltelement und das zweite Schaltelement jeweils durch einen MOSFET oder dergleichen gebildet.

In einer vorteilhaften Ausgestaltung der Erfindung ist der Gleichspannungswandler in einen integrierten Schaltkreis integriert. Der "integrierte Schaltkreis" (engl. integrated circuit) wird häufig auch als IC oder Mikrochip bezeichnet.

In einer vorteilhaften Ausgestaltung der Erfindung ist der Gleichspannungswandler mit einer einstellbaren maximalen Ausgangsspannung ausgestaltet. Auf diese Weise kann der Gleichspannungswandler der erfindungsgemäßen Treiberschaltung in vorteilhafter Weise an den jeweiligen Halbleiterschalter angepasst werden. Der maximale Pulsstrom zum Einschalten des Halbleiterschalters kann so durch die eingestellte bzw. programmierte maximale Ausgangsspannung und den elektrischen Widerstand des Strompfades zwischen dem Ausgangsanschluss des Gleichspannungswandlers und dem Steueranschluss des Halbleiterschalters vorgegeben werden.

In einer weiteren vorteilhaften Ausgestaltung der Erfindung ist der Gleichspannungswandler mit einem einstellbaren maximalen Ladestrom ausgestaltet. Auch auf diese Weise kann der Gleichspannungswandler der erfindungsgemäßen Treiberschaltung in vorteilhafter Weise an den jeweiligen Halbleiterschalter angepasst werden.

Das erfindungsgemäße Verfahren zum Ansteuern eines stromgesteuerten Halbleiterschalters ist **dadurch gekennzeichnet, dass** ein Ansteuerstrom zum Einschalten des Halbleiterschalters und ein Ansteuerstrom zum Halten des Halbleiterschalters im eingeschalteten Zustand jeweils von einer Treiberschaltung mit (genau) einem Gleichspannungswandler bereitgestellt werden.

Die besonderen Vorteile dieses Verfahrens entsprechen jenen der oben beschriebenen Treiberschaltung der Erfindung.

Vorzugsweise wird zum Einschalten des Halbleiterschalters zunächst eine Ausgangskapazität des Gleichspannungswandlers auf eine maximale Ausgangsspannung geladen (Konstantspannungsmodus) und dann wird ein Ausgangsanschluss des Gleichspannungswandlers mit einem Steueranschluse des Halbleiterschalters verbunden. Der Halbleiterschalter wird so mit einem relativ hohen Pulsstrom eingeschaltet.

Um eine Anpassung des Ansteuerverfahrens an den jeweiligen Halbleiterschalter zu ermöglichen, ist die maximale Ausgangsspannung des Gleichspannungswandlers vorzugsweise einstellbar. Der maximale Pulsstrom zum Einschalten des Halbleiterschalters kann so durch die eingestellte bzw. programmierte maximale Ausgangsspannung und den elektrischen Widerstand des Strompfades zwischen dem Ausgangsanschluss des Gleichspannungswandlers und dem Steueranschluss des Halbleiterschalters vorgegeben werden.

Vorzugsweise bleibt zum Halten des Halbleiterschalters im eingeschalteten Zustand der Steueranschluss des Halbleiterschalters mit dem Ausgangsanschluss des Gleichspannungswandlers verbunden, während die Ausgangskapazität des Gleichspannungswandlers mit einem maximalen Ladestrom geladen wird (Konstantstrommodus). Da der Gleichspannungswandler die angeschlossene Last in Form des Halbleiterschalters anhand des Spannungsabfalls an der Ausgangskapazität erkennt, startet der Gleichspannungswandler wieder den Ladevorgang der Ausgangskapazität, wobei der eingestellte maximale Ladestrom berücksichtigt wird. Der Halbleiterschalter wird so mit einem Dauerstrom, welcher üblicherweise niedriger (d.h. kleinere Amplitude) als der Pulsstrom zum Einschalten ist, im eingeschalteten Zustand gehalten.

Um eine Anpassung des Ansteuerverfahrens an den jeweiligen Halbleiterschalter zu ermöglichen, ist der maximale Ladestrom des Gleichspannungswandlers vorzugsweise einstellbar.

Vorzugsweise wird zum Ausschalten des Halbleiterschalters der Steueranschluss des Halbleiterschalters von dem Ausgangsanschluss des Gleichspannungswandlers getrennt und mit einem Stromanschluss des Halbleiterschalters verbunden. Auf diese Weise kann die Millerkapaaität des Halbleiterschalters schnell entladen werden. Gleichzeitig kann die Ausgangskapazität des Gleichspannungswandlers auf die eingestellte maximale Ausgangsspannung aufgeladen werden.

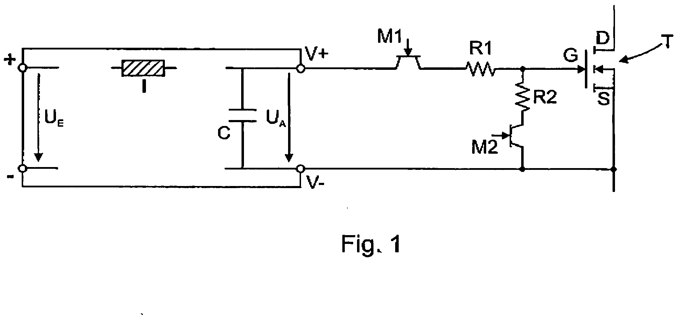

Obige sowie weitere Merkmale und Vorteile der Erfindung werden aus der nachfolgenden Beschreibung eines bevorzugten, nicht-einschränkenden Ausführungsbeispiels unter Bezugnahme auf die beiliegende Zeichnung besser verständlich. Darin zeigt die einzige Figur 1 ein stark vereinfachtes Blockschaltbild einer Treiberschaltung für einen stromgesteuerten Halbleiterschalter gemäß einem Ausführungsbeispiel der vorliegenden Erfindung.

Der stromgesteuerte Halbleiterschalter T in Figur 1 besitzt in üblicher Weise zwei Stromanschlüsse (Drain-Elektrode D und Source-Elektrode S) sowie einen Steueranschluss (Gate-Elektrode G). Im Fall von Bipolartransistoren wird der Steueranschluss als Basis B bezeichnend und werden die Stromanschlüsse als Emitter E und Kollektor C bezeichnet.

Die Treiberschaltung hat als wesentliche Komponente (genau) einen Gleichspannungswandler DC-DC mit zwei Eingangsanschlüssen, an denen (genau) eine Eingangsspannung U_{E} angelegt werden kann, und zwei Ausgangsanschlüssen V+ und V-, an denen eine Ausgangsspannung U_{A} abgegriffen werden kann. Üblicherweise enthält der Gleichspannungswandler DC-DC eine Ausgangskapazität C, die über eine Induktivität I geladen wird. Im Übrigen ist der Gleichspannungswandler DC-DC auf keine spezielle Ausgestaltung beschränkt.

Der positive Ausgangsanschluss V+ des Gleichspannungswandiers DC-DC ist über ein erstes Schaltelement M1 (z.B. Niederspannungs-MOSFET) und einen ersten Widerstand R1 mit dem Steueranschluss G des Halbleiterschalters T verbunden. Der erste Widerstand R1 kann im Vergleich zu herkömmlichen Treiberschaltungen sehr klein gewählt werden oder es kann sogar ganz auf ihn verzichtet werden, da die internen Widerstände des Halbleiterschalters T verwendet werden können, um den vom Gleichspannungswandler DC-DC zum Halbleiterschalter T fließenden Strom zu begrenzen. Der negative Ausgangsanschluss V- des Gleichspannungswandlers DC-DC ist mit der Seite des einen Stromanschlusses S des Halbleiterschalters T verbunden.

Ein zweites Schaltelement M2 (z.B. Niederspannungs-MOSFET) ist zwischen den Steueranschluss G und den einen Stromanschluss S des Halbleiterschalters T geschaltet. In Reihe zu diesem zweiten Schaltelement M2 ist zudem ein zweiter Widerstand R2 geschaltet.

Der Gleichspannungswandler DC-DC ist vorzugsweise in einen integrierten Schaltkreis (IC, Mikrochip) integriert. Insbesondere ist ein einzelner Gleichspannungswandler DC-DC für die Treiberschaltung des Halbleiterschalters T ausreichend und es genügen wenige externe passive Bauteile. Da ein solcher Gleichspannungswandler DC-DC bereits auf dem Markt zur Verfügung steht und sehr zuverlässig und kostengünstig ist, lässt sich auf diese Weise auch eine zuverlässige und kostengünstige Treiberschaltung für Halbleiterschalter aufbauen.

Es wird nun die Funktionsweise der in Figur 1 dargestellten Treiberschaltung näher erläutert.

Zunächst wird die Ausgangskapazität C des Gleichspannungswandlers DC-DC über die Induktivität I auf die maximal mögliche Ausgangsspannung (z.B. etwa 15 V) aufgeladen (Konstantspannungsmodus). Zum Einschalten des Halbleiterschalters T wird der positive Ausgangsanschluss V+ des Gleichspannungswandlers DC-DC über das erste Schaltelement M1 mit dem Steueranschluss G des Halbleiterschalters T verbunden. Durch die vollständig aufgeladene Ausgangskapazität C des Gleichspannungswandlers DC-DC wird an den Steueranschluss G des Halbleiterschalters T ein guter Stromimpuls angelegt, der geeignet ist, die so genannte Millerkapazität des Halbleiterschalters T aufzuladen.

Die maximal mögliche Ausgangsspannung des Gleichspannungswandlers DC-DC ist vorzugsweise variabel einstellbar. Auf diese Weise kann die erfindungsgemäße Treiberschaltung an den jeweils anzusteuernden Halbleiterschalter angepasst werden. Insbesondere ist der maximale Pulsstrom zum Einschalten des Halbleiterschalters durch die eingestellte bzw. programmierte maximale Ausgangsspannung des Gleichspannungswandlers DC-DC und die Reihenschaltung aus erstem Schaltelement M1 und erstem Widerstand R1 zwischen dem Ausgangsanschluss V+ des Gleichspannungswandlers DC-DC und dem Steueranschluss G des Halbleiterschalters T vorgegeben.

Nach dem Einschalten des ersten Schaltelements M1 erfasst der Gleichspannungswandler DC-DC die angeschlossene Last des Halbleiterschalters T, da die Ausgangsspannung U_{A} unter den programmierten Wert sinkt. Der Gleichspannungswandler DC-DC beginnt deshalb wieder, die Ausgangskapazität C mit dem maximalen Ladestrom (z.B. etwa 300 mA) aufzuladen (auf z.B. etwa 4 V, Konstantstrommodus). Auf diese Weise wird der Steueranachluss G des Halbleiterschalters T mit dem Ladestrom des Gleichspannungswandlers DC-DC angesteuert und der Halbleiterschalter T so im eingeschalteten Zustand gehalten.

Der maximal mögliche Ladestrom des Gleichspannungswandlers DC-DC ist dabei vorzugsweise variabel einstellbar. Auch durch diese Maßnahme kann die erfindungsgemäße Treiberschaltung optimal an den jeweils anzusteuernden Halbleiterschalter angepasst werden.

Der Dauerstrom zum Halten des Halbleiterschalters T im eingeschalteten Zustand ist üblicherweise niedriger als der Pulsstrom zum Einschalten des Halbleiterschalters T, d.h. hat einen niedrigeren Amplitudenwert.

Um den Halbleiterschalter T auszuschalten, wird das erste Schaltelement M1 wieder geöffnet und wird das zweite Schaltelement M2 geschlossen. Auf diese Weise wird die interne Streukapazität des Halbleiterschalters T über den Zweig des zweiten Schaltelements M2 schnell entladen. Gleichzeitig lädt der Gleichspannungswandler DC-DC seine Ausgahgskapazität C wegen des geöffneten ersten Schaltelements M1 wieder auf die maximal mögliche Ausgangsspannung auf, sodass die Treiberschaltung wieder zum erneuten Einschalten des Halbleiterschalters T bereit ist.

Die Schaltfrequenz der beschriebenen Treiberschaltung ist vorzugsweise deutlich höher als jene des angeschlossenen Halbleiterschalters T. Zudem bewirkt die höhere Frequenz eine sehr kleine und damit kostengünstige Induktivität I, über deren Ripplestrom sich zudem die Genauigkeit des eingeprägten Gleichstroms einstellen lässt.

Die oben beschriebene Treiberschaltung der Erfindung ist insbesondere zum Ansteuern von Halbleiterschaltern mit neuen Materialien wie SiC und GaN vorteilhaft geeignet, welche häufig große Millerkapazitäten haben, ohne dass die Erfindung auf diese Anwendung beschränkt sein soll. Die Treiberschaltung kann zur weiteren Flexibilisierung auch mit weiteren Treiberschaltungselementen, wie beispielsweise einem ESBT - Treiber ausgestattet sein.

Trotz des nur einen Gleichspannungswandlers in der Treiberschaltung kann mit dieser eine zweistufige Ansteuerung des stromgesteuerten Halbleiterschalters realisiert werden. Im Gegensatz zur Verwendung von zwei parallel geschalteten, quasi unabhängigen, herkömmlichen Treibern ist die in Figur 1 veranschaulichte Treiberschaltung sehr einfach und aus relativ wenigen Komponenten aufgebaut.

## Patentansprüche

1. Treiberschaltung für einen stromgesteuerten Halbleiterschalter, mit einem Gleichspannungswandler (DC-DC) mit einem Ausgangsanschluss (V+) zum Bereitstellen eines Ansteuerstroms für einen Halbleiterschalter (T);
einem ersten Schaltelement (M1), das zwischen den Ausgangsanschluss (V+) des Gleichspannungswandlers (DC-DC) und einen Steueranschluss (G) des Halbleiterschalters (T) geschaltet ist; und
einem zweiten Schaltelement (M2), das zwischen den Steueranschluss (G) des Halbleiterschalters (T) und einen Stromanschluss (S) des Halbleiterschalters (T) geschaltet ist,
wobei der eine Gleichspannungswandler (DC-DC) in zwei Bethribsmodi mit unterschiedlichen Ausgangsströmen und/oder Ausgangsspannungen betreibbar ist.

2. Trelberschaltung nach Anspruch 1,
**dadurch gekennzeichnet, dass**
der Gleichspannungswandler (DC-DC) in einen integrierten Schaltkreis integriert ist.

3. Treiberschaltung nach einem der vorhergehenden Ansprüche,
**dadurch gekennzeichnet, dass**
der Gleichspannungswandler (DC-DC) mit einer einstellbaren maximalen Ausgangsspannung ausgestaltet ist.

4. Treiberschaltung nach einem der vorhergehenden Ansprüche,
**dadurch gekennzeichnet, dass**
der Gleichspannungswandler (DC-DC) mit einem einstellbaren maximalen Ladestrom ausgestaltet ist.

5. Verfahren zum Ansteuern eines stromgesteuerten Halbleiterschalters,
**dadurch gekennzeichnet, dass**
ein Ansteuerstrom zum Einschalten des Halbleiterschafters (T) und ein Ansteuerstrom zum Halten des Halbleiterschalters (T) im eingeschalteten Zustand jeweils von einer Treiberschaltung mit einem Gleichspannungswandler (DC-DC) bereitgestellt werden.

6. Verfahren nach Anspruch 5,
**dadurch gekennzeichnet, dass**
zum Einschalten des Halbleiterschalters (T) zunächst eine Ausgangskapazität (C) des Gleichspannungswandlers (DC-DC) auf eine maximale Ausgangsspannung geladen wird und dann ein Ausgangsanschluss (V+) des Gleichspannungswandlers (DC-DC) mit einem Steueranschluss (G) des Halbleiterschalters (T) verbunden wird.

7. Verfahren nach Anspruch 6,
**dadurch gekennzeichnet, dass**
die maximale Ausgangsspannung des Gleichspannungswandlers (DC-DC) einstellbar ist.

8. Verfahren nach einem der Ansprüche 5 bis 7,
**dadurch gekennzeichnet, dass**
zum Halten des Halbleiterschalters (T) im eingeschalteten Zustand der Steueranschluss (G) des Halbleiterschalters (T) mit dem Ausgangsanschluss (V+) des Gleichspannungswandlers (DC-DC) verbunden bleibt, während die Ausgangskapazität (C) des Gleichspannungswandlers (DC-DC) mit einem maximalen Ladestrom geladen wird.

9. Verfahren nach Anspruch 8,
**dadurch gekennzeichnet, dass**
der maximale Ladestrom des Gleichspannungswandlers (DC-DC) einstellbar ist.

10. Verfahren nach einem der Ansprüche 5 bis 9,
**dadurch gekennzeichnet, dass**
zum Ausschalten des Halbleiterschalters (T) der Steueranschluss (G) des Halbleiterschalters (T) von dem Ausgangsanschluss (V+) des Gleichspannungswandlers (DC-DC) getrennt und mit einem Stromanschluss (S) des Halbleiterschalters (T) verbunden wird.
